(19) **Europäisches Patentamt**

**European Patent Office**

**Office européen des brevets**

(11) Publication number : **0 476 844 A1**

(12) **EUROPEAN PATENT APPLICATION**

(21) Application number : **91307705.3**

(22) Date of filing : **21.08.91**

(51) Int. Cl.⁵ : **H01L 39/24**

(30) Priority : **21.09.90 US 586911**

(43) Date of publication of application :
**25.03.92 Bulletin 92/13**

(84) Designated Contracting States :
**DE FR GB**

(71) Applicant : **TRW INC.**
**1900 Richmond Road**
**Lyndhurst Ohio 44124 (US)**

(72) Inventor : **Lee, Luke PyungeSe**
**22115 Caminito Amor**
**Laguna Beach, California 90287 (US)**
Inventor : **Chan, Hugo Wai-Kung**
**6960 Starstone Dr.**
**Palos Verdes, California 90205 (US)**
Inventor : **Sandell, Robert Dunlap**
**1305 Oak Ave.**
**Manhattan Beach, California 90266 (US)**

(74) Representative : **Allden, Thomas Stanley et al**
**A.A. THORNTON & CO. Northumberland**
**House 303-306 High Holborn**
**London WC1V 7LE (GB)**

(54) **Method for fabricating Josephson tunnel junctions with accurate junction area control.**

(57)   A fabrication method for Josephson tunnel junctions in which a laminated junction layer is formed on a substrate. The laminated junction layer includes an insulating layer sandwiched between a superconducting base electrode layer and a superconducting counter electrode layer. The counter electrode layer is then covered with a photoresist layer which is patterned to define the junction areas. The patterned photoresist layer is then hardened by plasma or deep UV treatment and the counter electrode layer is partially etched by plasma or reactive ion etching. The device is then anodized to convert the exposed areas of the counter electrode layer to an insulating material, thus isolating the individual Josephson junctions. The hardened photoresist layer is then removed and electrical contacts to the counter electrodes are formed. The hardening of the photoresist layer and the partial etching of the counter electrode layer minimizes anodization under the photoresist material to provide accurate control of the dimensions of the junction area.

EP 0 476 844 A1

FIG. 2a

FIG. 2b

FIG. 2c

FIG. 2d

## BACKGROUND OF THE INVENTION

This invention relates generally to methods for fabricating superconducting Josephson tunnel junctions and, more particularly, to methods for fabricating multiple Josephson junctions using anodization for isolating the individual Josephson junctions.

A superconducting Josephson tunnel junction is a bistable switching device having a very thin insulating or barrier layer sandwiched between two superconducting electrodes. When current supplied to the Josephson junction is increased above the junction's critical current, the device is switched from a superconducting zero-voltage state to a resistive voltage state. The resistive voltage state is switched off by reducing the current supplied to the junction to about zero. Because this switching operation can occur in as little as a few picoseconds, the Josephson junction is a very high speed switching device which is particularly useful in superconducting electronic devices.

Josephson junctions are frequently fabricated using a process disclosed in U.S. Patent No. 4,421,785 to Kroger, commonly referred to as Selective Non-Anodizing Process, or SNAP. In this process, a laminated junction layer is deposited on a substrate in a single vacuum run, thus preventing contamination of the junction region. The laminated junction layer includes an insulating or barrier layer sandwiched between a superconducting base electrode layer and a superconducting counter electrode layer. The counter electrode layer is then covered with a photoresist layer and the photoresist is patterned and etched using conventional photolithographic techniques to define the junction areas. The device is then anodized to convert the exposed areas of the counter electrode layer to an insulating material, thus isolating the individual Josephson junctions. The photoresist is then removed and electrical contacts to the counter electrodes are formed.

Although this fabrication method is widely used and has many advantages, it has several disadvantages. The most significant of these disadvantages is inaccurate control of the junction area, particularly for junction areas having dimensions less than a micron. Small junction areas are desirable because they increase the speed of the device and allow more junctions to be packed onto the substrate, thus saving space and decreasing signal propagation time between the junctions. Inaccurate control of the junction area is due to the anodization of the counter electrode layer. Anodization is an electrolytic reaction in which the superconducting metal is made to accept oxygen atoms, thus converting the metal to an insulator. However, the addition of oxygen atoms to the metal also causes the metal to expand and lift the photoresist from the counter electrode layer. This allows oxidation to occur under the photoresist layer, thus seriously limiting the ability of the photoresist to define the junction area. Accordingly, there has been a need for a method for fabricating Josephson tunnel junctions that does not suffer from this disadvantage. The present invention clearly ful fills this need.

## SUMMARY OF THE INVENTION

The present invention resides in a method for fabricating Josephson tunnel junctions which provides accurate control of the dimensions of the junction area. In the fabrication method of the present invention, a laminated junction layer is deposited on the upper surface of an insulating substrate. The laminated junction layer includes an insulating or barrier layer sandwiched between a superconducting base electrode layer and a superconducting counter electrode layer. The laminated junction layer is formed in successive layers by either sputtering or evaporation in the same vacuum run to prevent contamination of the junction region.

A photoresist layer is then deposited on the upper surface of the laminated junction layer and patterned and etched using conventional photolithographic techniques to define the junction areas. The patterned photoresist layer is then hardened by plasma or deep ultraviolet (UV) treatment and the counter electrode layer is partially etched by plasma or reactive ion etching. The counter electrode layer is etched from about 50% to almost 100% of its thickness. The device is then anodized to convert the exposed areas of the counter electrode layer to an insulating material, thus isolating the individual Josephson junctions. The hardened photoresist layer is then removed and electrical contacts to the counter electrodes are formed.

The hardening of the patterned photoresist layer stabilizes the developed photoresist image, thus providing more accurate control of the junction area. The hardening of the patterned photoresist layer also inhibits the anodizing solution from penetrating underneath the photoresist layer, which would otherwise oxidize the counter electrode layer under the photoresist layer. The partial etching of the counter electrode layer also aids in minimizing oxidation under the hardened photoresist layer by reducing the time required for anodization. Minimized oxidation under the hardened photoresist layer allows submicron junctions to be fabricated with accurate control of the junction area.

It will be appreciated from the foregoing that the present invention represents a significant advance in the field of superconducting Josephson tunnel junctions. The fabrication method of the present invention provides high quality, fine geometry submicron Josephson junctions and allows either overlap or inside contacts to be made to the junction devices. Other features and advantages of the present invention will become apparent from the following more detailed description, taken in conjunct ion with the accompanying drawings, which illustrate, by way of example, the principles of the invention.

## BRIEF DESCRIPTION OF THE DRAWINGS

Figures 1a-1d are cross-sectional views depicting the steps for fabricating a Josephson tunnel junction in accordance with a prior art method;
Figures 2a-2d are cross-sectional views depicting the steps for fabricating a Josephson tunnel junction in accordance with the present invention;
Figures 3a-3b are scanning electron microscope photographs showing a beneficial effect of plasma hardening of the photoresist layer; and
Figures 4a-4b are scanning electron microscope photographs showing the beneficial results of the fabrication method of the present invention.

## DETAILED DESCRIPTION OF THE PREFERRED EMBODIMENT

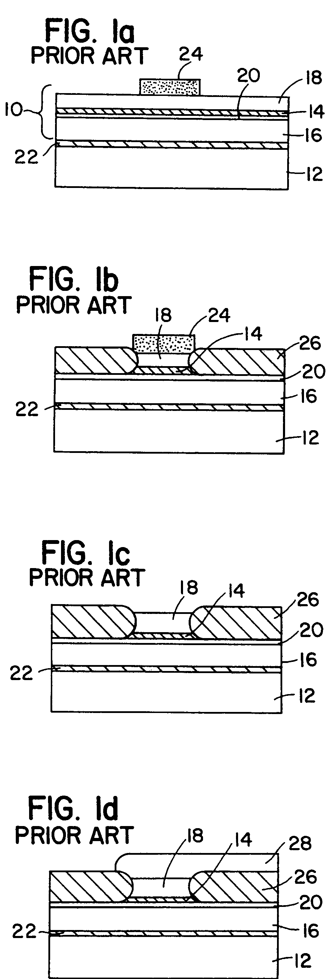

Figures 1a-1d illustrate the steps of a prior art method for fabricating superconducting Josephson tunnel junctions commonly referred to as Selective Non-Anodizing Process, or SNAP. As shown in Figure 1a, a laminated junction layer 10 is deposited on the upper surface of an insulating substrate 12. The laminated junction layer 10 includes an insulating or barrier layer 14 sandwiched between a superconducting base electrode layer 16 and a superconducting counter electrode layer 18. The laminated junction layer 10 is formed in successive layers by either sputtering or evaporation in the same vacuum run to prevent contamination of the junction region.

The superconducting electrode layers 16, 18 are preferably a refractory metal, such as niobium (Nb). The insulating or barrier layer 14 is preferably formed by thermally oxidizing the surface of a thin metal layer 20 deposited on the upper surface of the base electrode layer 16. A suitable metal for layer 20 is aluminum (Al), which when oxidized produces a barrier layer 14 of aluminum oxide ($Al_2O_3$). The insulating substrate 12 is preferably a silicon (Si) wafer having a dielectric layer 22 of silicon dioxide ($SiO_2$) formed on its upper surface by oxidation. In an exemplary laminated junction layer 10, the base electrode layer 16 is approximately 200 nm, the thin metal layer 20 is between 0.5 and 0.8 nm and the counter electrode layer 18 is approximately 35 nm.

A photoresist layer 24 is then deposited on the upper surface of the laminated junction layer 10 and patterned and etched using conventional photolithographic techniques to define the junction areas. As illustrated in Figure 1b, the device is then anodized to convert the exposed areas of the counter electrode layer 18 to an insulating layer 26, thus isolating the individual Josephson junctions. To prevent an electrical short between the junctions, the anodization must continue until the insulating layer 26 extends completely down through the counter electrode layer 18 to at least the barrier layer 14. The patterned photoresist layer 24 is then removed, as shown in Figure 1c, and electrical contacts 28 to the counter electrodes are formed, as illustrated in Figure 1d.

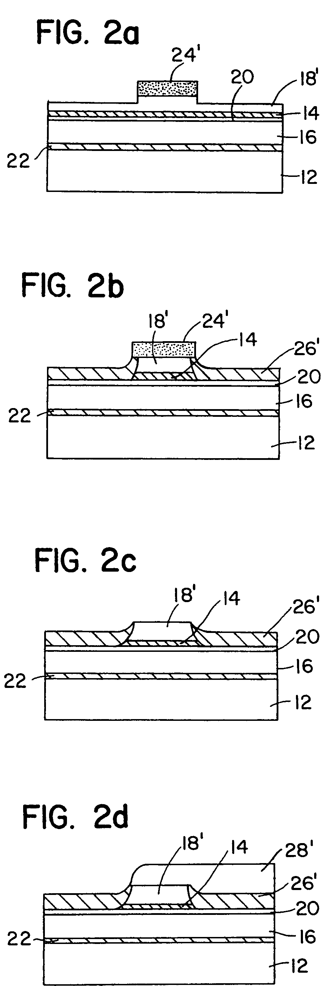

In accordance with the fabrication method of the present invention, the laminated junction layer 10 and the patterned photoresist layer 24 are formed as in the SNAP method illustrated in Figure 1a. The patterned photoresist layer 24 is then hardened to form a hardened photoresist layer 24' and the counter electrode layer 18 is partially etched to form an etched counter electrode layer 18', as illustrated in Figure 2a. The photoresist layer 24 is hardened by plasma or deep ultraviolet (UV) treatment and the counter electrode layer 18 is partially etched by plasma or reactive ion etching. Preferably, the plasma etching is performed using a fluorocarbon etchant, such as a mixture of $CF_4$ and $O_2$. Plasma etching with the $CF_4$ and $O_2$ mixture will also further harden the photoresist layer 24', and can be used for both hardening of the photoresist layer 24 and etching of the counter electrode layer 18. The counter electrode layer 18 is etched from about 50% to almost 100% of its thickness.

As shown in Figure 2b, the device is then anodized to convert the exposed areas of the counter electrode layer 18' to an insulating layer 26', thus isolating the individual Josephson junctions. To prevent an electrical short between the junctions, the anodization must continue until the insulating layer 26' extends completely down through the counter electrode layer 18' to at least the barrier layer 14. The electrolyte used in the anodization process is preferably a mixture of 156 g ammonium pentaborate, 1120 ml ethylene glycol, and 760 ml $H_2O$. A platinum cathode is used with a current density of about 2 $mA/cm^2$. The anodization process converts the niobium counter electrode layer 18' to niobium pentoxide ($Nb_2O_5$). The insulating layer 26' not only isolates the junction areas but also seals the junction edges and smoothens the upper surface of the device. The hardened photoresist layer 24' is then removed, as shown in Figure 2c, and electrical contacts 28' to the counter electrodes are formed, as illustrated in Figure 2d.

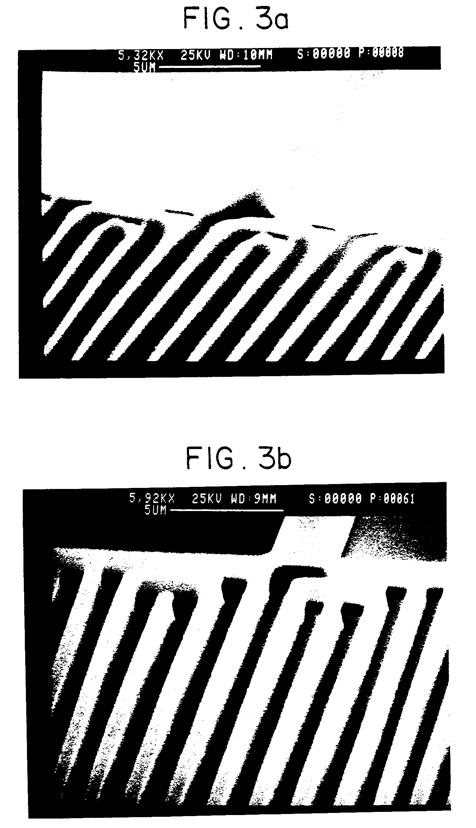

The hardening of the patterned photoresist layer 24 stabilizes the developed photoresist image, thus providing more accurate control of the junction area. The hardening process allows the photoresist to be baked in excess of 120 degrees C with no measurable change in resist dimensions. Figures 3a and 3b are scanning electron microscope (SEM) photographs showing the effects of the plasma hardening process on the sidewall profiles of photoresist patterns heated to 120 degrees C for 90 seconds. Figure 3a shows the patterned photoresist layer 24 without the hardening treatment, which flowed when heated, and Figure 3b shows the patterned photoresist layer with the hardening treatment.

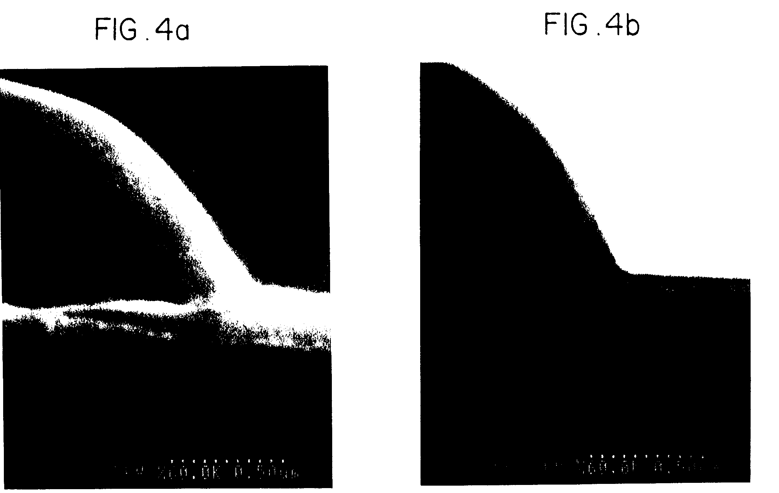

The hardening of the patterned photoresist layer 24 also inhibits the electrolyte from penetrating underneath the photoresist layer, which would otherwise oxidize the counter electrode layer 18 under the photoresist layer 24. The partial etching of the counter electrode layer 18 also aids in minimizing oxidation under the hardened photoresist layer 24' by reducing the time required for anodization. Minimized oxidation under the hardened photoresist layer 24' allows submicron junctions to be fabricated with accurate control of the junction area. Figures 4a and 4b are SEM photographs showing the beneficial effects of the hardening and partial etching steps on the amount of oxidation that occurs underneath the photoresist layer. Figure 4a shows the extensive oxidation under the patterned photoresist layer 24 without the hardening and partial etching treatment and Figure 4b shows the minimized oxidation under the patterned photoresist layer 24' with the hardening and partial etching treatment.

From the foregoing, it will be appreciated that the present invent ion represents a significant advance in the field of superconducting Josephson tunnel junctions. The fabrication method of the present invention provides high quality, fine geometry submicron Josephson junctions and allows either overlap or inside contacts to be made to the junction devices. Although a preferred embodiment of the invention has been shown and described, it will be apparent that other adaptations and modifications can be made without departing from the spirit and scope of the invention. Accordingly, the invention is not to be limited, except as by the following claims.

## Claims

1. A method for fabricating a superconducting Josephson junction, comprising the steps of:
   forming a laminated junction layer on a substrate, the junction layer including an insulating layer sandwiched between a superconducting base electrode layer and a superconducting counter electrode layer;
   covering the counter electrode layer with a photoresist layer;
   patterning the photoresist layer to define a junction area and an exposed area;
   hardening the photoresist layer;
   partially etching the exposed area of the counter electrode layer;
   anodizing the exposed area of the counter electrode layer to convert the exposed area of the layer to an insulator;
   removing the photoresist layer; and
   forming an electrical contact to the counter electrode layer;
   wherein the photoresist layer is hardened and the counter electrode layer is partially etched to minimize anodization under the photoresist layer, thereby providing accurate control of the dimensions of the junction area.

2. The method for fabricating a superconducting Josephson junction as set forth in claim 1, wherein the photoresist layer is hardened by plasma treatment.

3. The method for fabricating a superconducting Josephson junction as set forth in claim 1, wherein the photoresist layer is hardened by deep ultraviolet (UV) treatment.

4. The method for fabricating a superconducting Josephson junction as set forth in claim 1, wherein the counter electrode layer is partially etched by reactive ion etching.

5. The method for fabricating a superconducting Josephson junction as set forth in claim 1, wherein the counter electrode layer is partially etched by plasma etching.

6. The method for fabricating a superconducting Josephson junction as set forth in claim 5, wherein the plasma etching uses a fluorocarbon etchant of $CF_4$ and $O_2$.

7. The method for fabricating a superconducting Josephson junction as set forth in claim 1, wherein the counter electrode layer is partially etched from about 50% to almost 100% of its thickness.

8. A method for fabricating a superconducting Josephson junction, comprising the steps of:
   forming a laminated junction layer on a substrate, the junction layer including an insulating layer sandwiched between a superconducting base electrode layer and a superconducting counter electrode layer;
   covering the counter electrode layer with a mask layer;
   patterning the mask layer to define a junction area and an exposed area;
   partially etching the exposed area of the counter electrode layer;
   anodizing the exposed area of the counter electrode layer to convert the exposed area of the layer to an insulator;
   removing the mask layer; and
   forming an electrical contact to the counter electrode layer;
   wherein the counter electrode layer is partially etched to minimize anodization under the mask layer, thereby providing accurate control of the dimensions of the junction area.

9. The method for fabricating a superconducting Josephson junction as set forth in claim 8, wherein the counter electrode layer is partially etched by reactive ion etching.

10. The method for fabricating a superconducting Josephson junction as set forth in claim 8, wherein the counter electrode layer is partially etched by plasma etching.

11. The method for fabricating a superconducting Josephson junction as set forth in claim 10, wherein the plasma etching uses a fluorocarbon etchant of $CF_4$ and $O_2$.

12. The method for fabricating a superconducting Josephson junction as set forth in claim 8, wherein the counter electrode layer is partially etched from about 50% to almost 100% of its thickness.

13. A method for fabricating a superconducting Josephson junction, comprising the steps of:
    forming a laminated junction layer on a substrate, the junction layer including an insulating layer sandwiched between a superconducting base electrode layer and a superconducting counter electrode layer;
    covering the counter electrode layer with a photoresist layer;
    patterning the photoresist layer to define a junction area and an exposed area;
    hardening the photoresist layer;
    anodizing the exposed area of the counter electrode layer to convert the exposed area of the layer to an insulator;
    removing the photoresist layer; and
    forming an electrical contact to the counter electrode layer;
    wherein the photoresist layer is hardened to minimize anodization under the photoresist layer, thereby providing accurate control of the dimensions of the junction area.

14. The method for fabricating a superconducting Josephson junction as set forth in claim 13, wherein the photoresist layer is hardened by plasma treatment.

15. The method for fabricating a superconducting Josephson junction as set forth in claim 13, wherein the photoresist layer is hardened by deep ultraviolet (UV) treatment.

# FIG. Ia
## PRIOR ART

# FIG. Ib
## PRIOR ART

# FIG. Ic
## PRIOR ART

# FIG. Id
## PRIOR ART

FIG. 2a

FIG. 2b

FIG. 2c

FIG. 2d

## FIG . 3a

## FIG . 3b

FIG. 4a

FIG. 4b

EP 0 476 844 A1

**European Patent Office**

**EUROPEAN SEARCH REPORT**

Application Number

EP 91 30 7705

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4 589 961 (M. GERSHENSON) * column 5, line 58 - column 10, line 30; figures 1-2d; claims 7,8 * | 13,14 | H 01 L 39/24 |
| A | | 1-3,7,8 ,12,15 | |
| A | EP-A-0 095 773 (NEC) * abstract; figures 1A-1F * | 8 | |
| A | EP-A-0 387 982 (IBM) * abstract * | 13 | |
| A | IBM TECHNICAL DISCLOSURE BULLETIN vol. 32, no. 2, July 1989, pages 79,80, New York, US; "In-Situ Resist Hardening For Anisotrophic Etching in High Pressure Plasma Reactors" * whole document * | 1,2,4,5 ,9,10, 13,14 | |
| A | RESEARCH DISCLOSURE no. 277, entry no. 19, May 1987, page 296, New York, US; ANONYMOUS: "A Sidewall Image Definition Technique for Producing Extremely Fine Semiconductor Chip Features" * whole document * | 1,2,4-6 ,9-11, 13,14 | TECHNICAL FIELDS SEARCHED (Int. Cl.5) H 01 L G 03 F |

The present search report has been drawn up for all claims

| Place of search | Date of completion of the search | Examiner |
|---|---|---|
| BERLIN | 11-11-1991 | JUHL A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)

11